# EUROPEAN PATENT APPLICATION

(11) **EP 4 412 248 A1**
(43) Date of publication of application: **07.08.2024**
(21) Application number: 22875684.7
(22) Date of filing: 29.08.2022
(51) Int. Cl.: H04R 17/00

(54) **ULTRASONIC SENSOR**

(30) Priority: 29.09.2021 JP 2021158580
(71) Applicant: Murata Manufacturing Co., Ltd., Nagaokakyo-shi, Kyoto 617-8555 (JP)
(72) Inventor: NAKANISHI, Hirokazu, Nagaokakyo-shi, Kyoto 617-8555 (JP)
(74) Representative: Reeve, Nicholas Edward
(86) International application number: PCT/JP2022/032398
(87) International publication number: WO 2023/053812

(57) **Abstract**

An ultrasonic sensor includes a vibration body (2) including a cylindrical portion (2b) and a bottom portion (2a) that closes one end of the cylindrical portion (2b), a piezoelectric element fixed to an inner surface of the bottom portion (2a) of the vibration body (2), a first housing member (51) that constitutes at least a part of a housing storing the vibration body (2), and a first elastic member (4) that is disposed while being interposed between the vibration body (2) and the first housing member (51). The first elastic member (4) has a front and rear symmetrical shape and includes a closed-cell structure.

## Description

### Technical Field

The present invention relates to an ultrasonic sensor.

### Background Art

An example of an ultrasonic sensor is described in Japanese Patent No. 4438667 (Patent Document 1). The ultrasonic sensor described in Patent Document 1 includes an ultrasonic transducer. The ultrasonic transducer includes a housing having a cylindrical shape with a bottom, a piezoelectric element fixed to a bottom portion of the housing, and a base fixed to an opening of the housing with a spacer interposed therebetween. The spacer is made of an elastic body. The housing includes the bottom portion and a cylindrical portion. The spacer is an elastic body that prevents unnecessary vibration, caused by vibration of the bottom portion, generated in the cylindrical portion from being transferred to the base. Such an ultrasonic transducer is covered with a cylindrical elastic body, and a foamed elastic body is disposed on a lower side of the base as an elastic body that suppresses vibration.

### Citation List

### Patent Document

Patent Document 1: Japanese Patent No. 4438667

### Summary of Invention

### Technical Problem

The spacer of Patent Document 1 has a rib shape, and an outer surface of the rib shape is exposed to an outer peripheral surface of the ultrasonic transducer so as to hinder vibration transfer. Since the spacer has a front and rear asymmetrical shape, attention is required during assembly so as not to make a mistake in arranging the front and the rear.

Patent Document 1 describes that the spacer is made of, for example, silicon rubber. However, such a spacer has a large specific gravity, and does not have a sufficient effect of hindering vibration transfer. When such a spacer is in contact with the housing, fluctuation in the frequency of unnecessary vibration and variation in the product characteristics may be caused.

Therefore, an object of the present invention is to provide an ultrasonic sensor of which the assembly operation is facilitated and which can suppress unnecessary vibration transfer as much as possible.

### Solution to Problem

In order to achieve the above-described object, an ultrasonic sensor based on the present invention includes a vibration body including a cylindrical portion and a bottom portion that closes one end of the cylindrical portion, a piezoelectric element fixed to an inner surface of the bottom portion of the vibration body, a first housing member that constitutes at least a part of a housing storing the vibration body, and a first elastic member that is disposed while being interposed between the vibration body and the first housing member. The first elastic member has a front and rear symmetrical shape and includes a closed-cell structure.

### Advantageous Effects of Invention

According to the present invention, since the first elastic member that is disposed while being interposed between the vibration body and the first housing member has a front and rear symmetrical shape and includes a closed-cell structure, an ultrasonic sensor of which the assembly operation is facilitated and which can suppress unnecessary vibration transfer as much as possible can be achieved. Brief Description of Drawings

[Fig. 1] Fig. 1 is a first perspective view of an ultrasonic sensor according to a first embodiment based on the present invention.
[Fig. 2] Fig. 2 is an exploded view of the ultrasonic sensor according to the first embodiment based on the present invention.
[Fig. 3] Fig. 3 is an exploded view related to a vibration body included in the ultrasonic sensor according to the first embodiment based on the present invention.
[Fig. 4] Fig. 4 is a second perspective view of the ultrasonic sensor according to the first embodiment based on the present invention.
[Fig. 5] Fig. 5 is a cross-sectional view taken along an arrow line V-V in Fig. 4.
[Fig. 6] Fig. 6 is a cross-sectional view taken along an arrow line VI-VI in Fig. 4.
[Fig. 7] Fig. 7 is a cross-sectional view of a portion illustrated in Fig. 5 in a state in which a first filling member and a second filling member are removed.
[Fig. 8] Fig. 8 is a cross-sectional view of a portion illustrated in Fig. 6 in a state in which the first filling member and the second filling member are removed.
[Fig. 9] Fig. 9 is an exploded view of some components of a component group illustrated in Fig. 2 when viewed in a different direction.
[Fig. 10] Fig. 10 is an exploded view of a component group illustrated in Fig. 9 in a state of being assembled halfway.
[Fig. 11] Fig. 11 is a perspective view of a state in which the vibration body, a second elastic member, and a second housing member included in the ultrasonic sensor according to the first embodiment based on the present invention are assembled.
[Fig. 12] Fig. 12 is a perspective view of a state in which a first elastic member 4 is assembled in a portion illustrated in Fig. 11.
[Fig. 13] Fig. 13 is a first explanatory diagram for illustrating advantages of the first elastic member including a closed-cell structure.
[Fig. 14] Fig. 14 is a second explanatory diagram for illustrating advantages of the first elastic member including a closed-cell structure.
[Fig. 15] Fig. 15 is a graph indicating magnitude of a reaction force generated around an elastic member with respect to a pushed-in amount given to the elastic member. Description of Embodiments

The dimensional ratios illustrated in the drawings do not always faithfully represent the actual dimensional ratios, and the dimensional ratios may be exaggerated for convenience of description. In the following description, when referring to the concept of above or below, it does not necessarily mean absolute above or below, but may mean relative above or below in the illustrated positions.

### (First Embodiment)

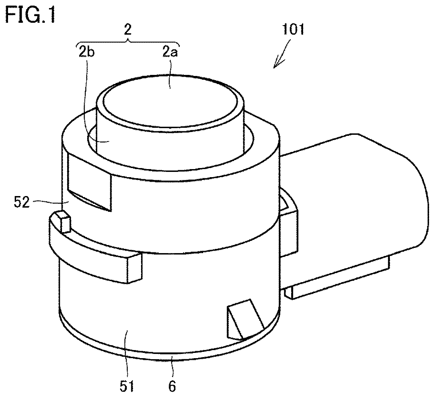

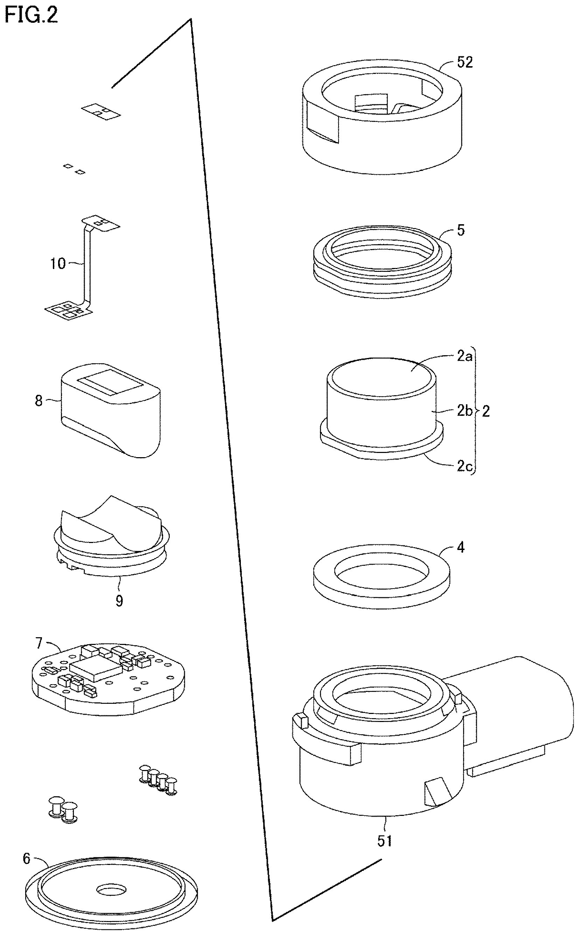

With reference to Figs. 1 to 12, an ultrasonic sensor according to a first embodiment based on the present invention will be described. Fig. 1 illustrates an ultrasonic sensor 101 according to the present embodiment. Fig. 2 illustrates an exploded view of the ultrasonic sensor 101. The ultrasonic sensor 101 includes a rear cover 6, a wiring board assembly 7, a first filling member 8, a second filling member 9, wiring 10, a first housing member 51, a first elastic member 4, a vibration body 2, a second elastic member 5, and a second housing member 52. The first elastic member 4 includes a closed-cell structure. The vibration body 2 has a cylindrical shape with a bottom. The vibration body 2 is made of, for example, metal. Here, the metal is, for example, aluminum. The vibration body 2 includes a bottom portion 2a, a cylindrical portion 2b, and a flange portion 2c. The first housing member 51 and the second housing member 52 are made of, for example, resin. The material of the first housing member 51 and the second housing member 52 may be the same kind. The rear cover 6 may be made of, for example, resin. The first filling member 8 is made of, for example, foamed silicone. The second filling member 9 is, for example, a silicone member disposed by potting processing. The second elastic member 5 is made of, for example, rubber.

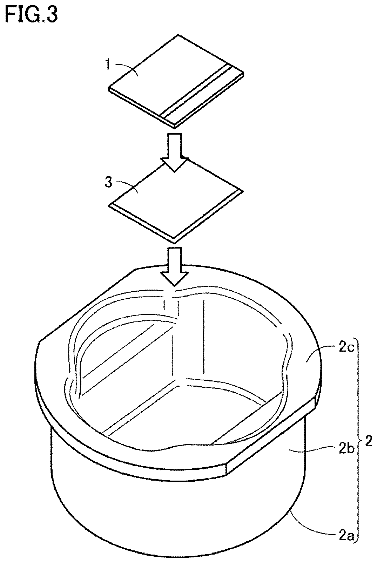

As illustrated in Fig. 3, a piezoelectric element 1 is disposed inside the vibration body 2. The piezoelectric element 1 is attached to an inner surface of the bottom portion 2a with an adhesive sheet 3 interposed therebetween. The adhesive sheet 3 may be a double-sided tape.

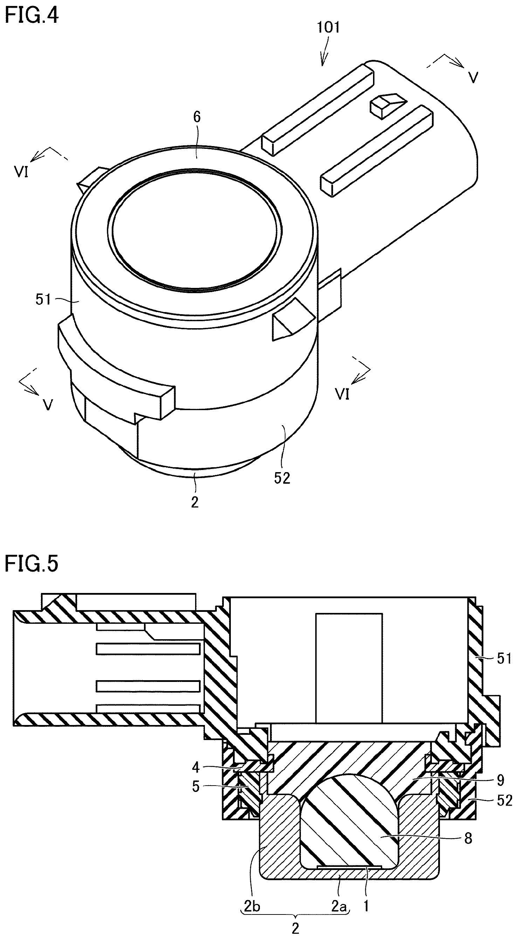

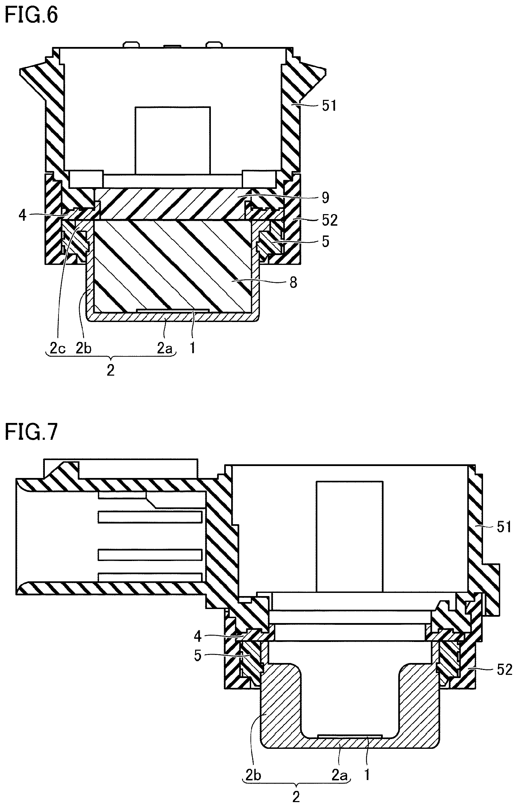

Fig. 4 illustrates the ultrasonic sensor 101 in an orientation in which the rear cover 6 faces up. The orientation illustrated in Fig. 4 corresponds to a state in which the ultrasonic sensor 101 illustrated in Fig. 1 is inverted in an up-and-down direction. Fig. 5 is a cross-sectional view taken along an arrow line V-V in Fig. 4. Fig. 6 is a cross-sectional view taken along an arrow line VI-VI in Fig. 4. In Figs. 5 and 6, the rear cover 6, the wiring board assembly 7, the wiring 10, the adhesive sheet 3, and the like are not illustrated.

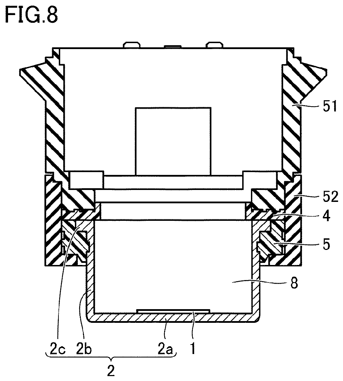

The first elastic member 4 is interposed between the vibration body 2 and the first housing member 51. The first filling member 8 is disposed inside the vibration body 2 so as to be in contact with the piezoelectric element 1 and the bottom portion 2a. Moreover, the second filling member 9 is disposed so as to cover the first filling member 8. A part of the second filling member 9 protrudes to the outside from the internal space of the vibration body 2. The first elastic member 4 has an annular shape. That is, the first elastic member 4 has an opening. The second filling member 9 penetrates the opening of the first elastic member 4. Fig. 7 illustrates a portion illustrated in Fig. 5 in a state in which the first filling member 8 and the second filling member 9 are removed. Fig. 8 illustrates a portion illustrated in Fig. 6 in a state in which the first filling member 8 and the second filling member 9 are removed.

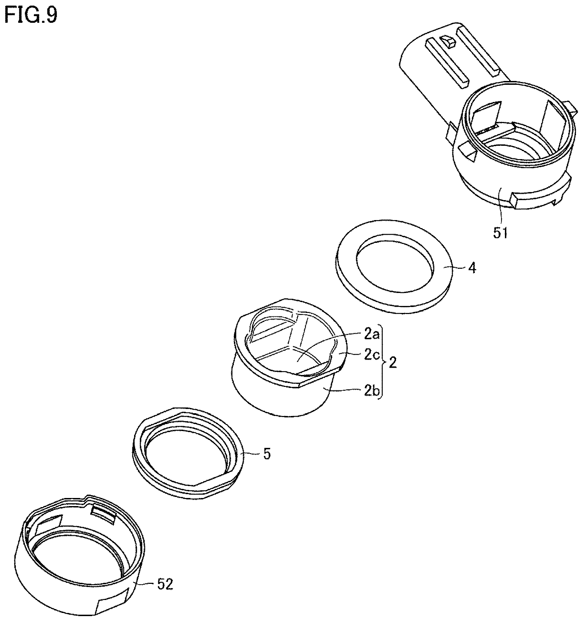

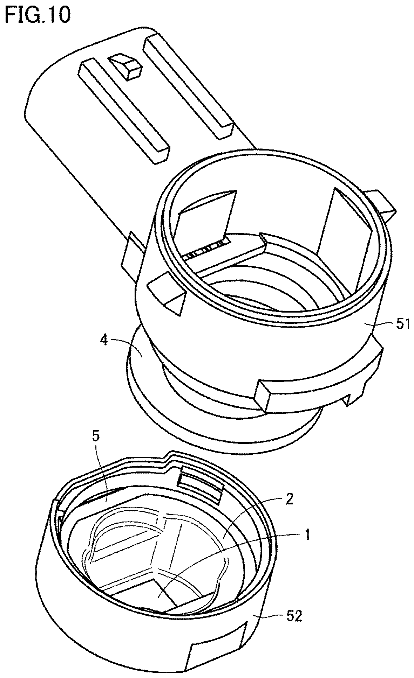

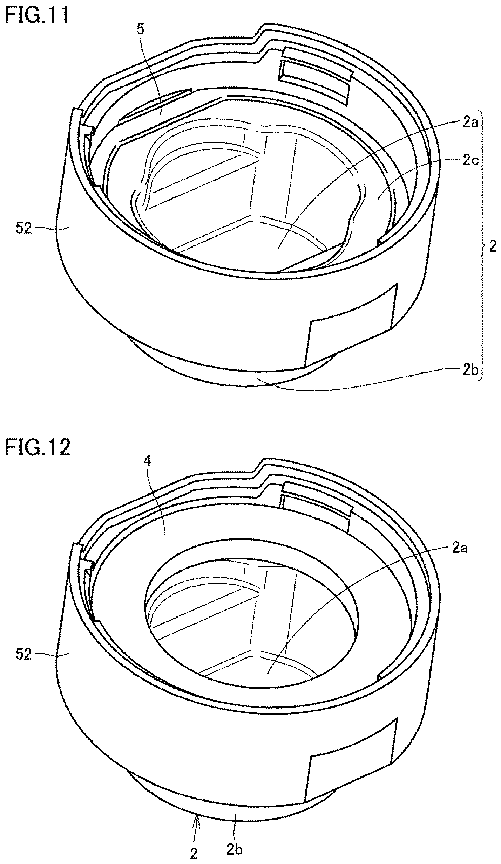

Fig. 9 is an exploded view of some components of a component group illustrated in Fig. 2 when viewed in a different direction. Fig. 9 illustrates the first housing member 51, the first elastic member 4, the vibration body 2, the second elastic member 5, and the second housing member 52. Fig 10 illustrates a state in which the above-described components are assembled halfway. Fig. 10 also illustrates the piezoelectric element 1 attached to the inner surface of the vibration body 2. Fig. 11 illustrates a state in which the vibration body 2, the second elastic member 5, and the second housing member 52 are assembled. Fig. 12 illustrates a state in which the first elastic member 4 is further assembled in a portion illustrated in Fig. 11

The configuration of the ultrasonic sensor 101 can be expressed as described below, for example. The ultrasonic sensor 101 includes the vibration body 2 including the cylindrical portion 2b and the bottom portion 2a that closes one end of the cylindrical portion 2b, the piezoelectric element 1 fixed to an inner surface of the bottom portion 2a of the vibration body 2, the first housing member 51 that constitutes at least a part of a housing storing the vibration body 2, and the first elastic member 4 that is disposed while being interposed between the vibration body 2 and the first housing member 51. The first elastic member 4 has a front and rear symmetrical shape and includes a closed-cell structure.

In the present embodiment, since the ultrasonic sensor 101 includes the first elastic member 4 that is disposed while being interposed between the vibration body 2 and the first housing member 51, and the first elastic member 4 includes a closed-cell structure, vibration transfer from the vibration body 2 to the first housing member 51 can be more effectively hindered. That is, unnecessary vibration transfer can be suppressed as much as possible. In addition, since the first elastic member 4 has a front and rear symmetrical shape, assembly operation can be performed without paying attention to distinction between the front and the rear. Therefore, the assembly operation is facilitated,

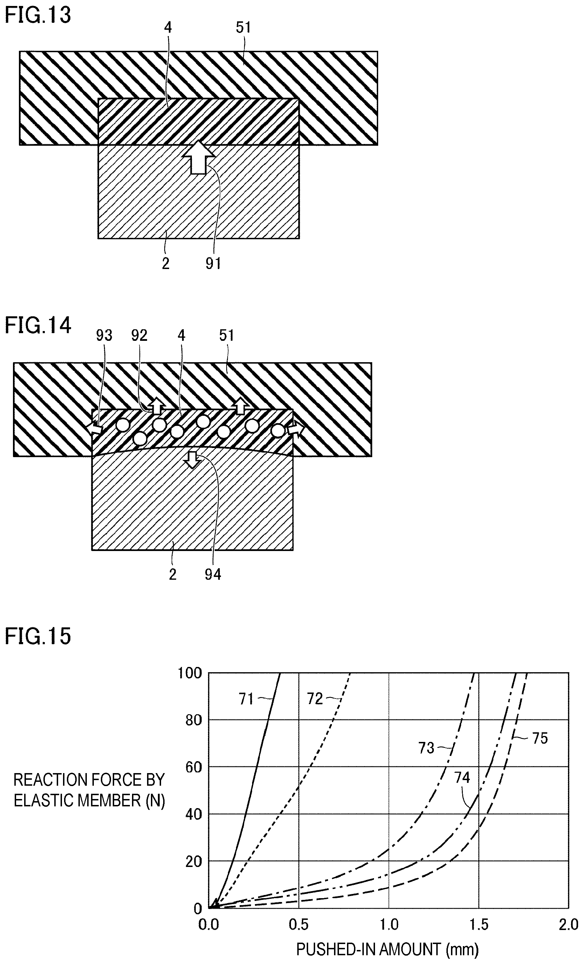

With reference to Figs. 13 and 14, advantages of the first elastic member 4 including a closed-cell structure will be described. In Figs. 13 and 14, for convenience of description, the structure is schematically illustrated. As illustrated in Fig. 13, the first elastic member 4 is interposed between the first housing member 51 and the vibration body 2, and it is assumed that when the vibration body 2 vibrates, an upper surface of the vibration body 2 is largely displaced upward as indicated by an arrow 91. As a result, a lower surface of the first elastic member 4 is pushed and is displaced so as to enter the inside of the first elastic member 4, thereby acting in a direction of reducing the volume of the first elastic member 4.

If the first elastic member 4 is made of rubber, the first elastic member 4 has a fixed Poisson ratio, and thus when the lower surface of the first elastic member 4 is pushed in, an upper surface and an outer peripheral surface of the first elastic member 4 is pushed out from the original surfaces by the amount corresponding to the volume pushed in. As a result, the first housing member 51 is pushed and displaced. When such displacement is repeated, vibration is transferred to the first housing member 51.

However, when the first elastic member 4 includes a closed-cell structure, each of the closed cells inside the first elastic member 4 can be compressed and contracted. Therefore, the imposed volume change is absorbed to some extent by the closed cells. As a result, as illustrated by arrows 92 and 93 in Fig. 14, the pushing force of the upper surface and the outer peripheral surface of the first elastic member 4 from the original surfaces toward outside is decreased. Therefore, the amount of displacement of the first housing member 51 being pushed is also reduced. As a result, the degree of vibration transfer to the first housing member 51 can be reduced.

Fig. 15 is a graph indicating the magnitude of a reaction force generated around an elastic member with respect to a pushed-in amount given to the elastic member. In Fig. 15, a curved line 71 indicates a case in which rubber having a hardness of 50 is used as the elastic member. A curved line 72 indicates a case in which rubber having a hardness of 30 is used as the elastic member. A curved line 73 indicates a case in which sponge having a hardness of 30 is used as the elastic member. A curved line 74 indicates a case in which sponge having a hardness of 20 is used as the elastic member. A curved line 75 indicates a case in which sponge having a hardness of 15 is used as the elastic member. The hardness of rubber is measured by a type A durometer (Asker A type) conforming to JIS K6253-3. The hardness of sponge is measured by a type E durometer (Asker C type) conforming to JIS K6253-3. JIS K6253-3 of the JIS standard corresponds to ISO 48-4 of the ISO standard. The curved lines 71 and 72 correspond to a case in which a member not including a closed-cell structure is used, and the curved lines 73, 74, and 75 correspond to a case in which a member including a closed-cell structure is used.

As illustrated in Fig. 15, compared to the curved lines 71 and 72, reaction forces of the curved lines 73, 74, and 75 tend to be suppressed small even with respect to the same pushed-in amount. The reaction forces being suppressed small means that unnecessary vibration transfer is easily suppressed.

Note that a member including closed cells does not easily allow water or the like to pass therethrough, compared to a member including open cells, and thus has high waterproof capability. When the member includes open cells, since air passes through the member, pickup by vacuum suction is difficult to perform, but when the member includes closed cells, since air does not pass through the member, pickup by vacuum suction is easily performed.

In addition, when the first filling member 8 and the second filling member 9 are formed, in a case in which forming is performed through filling with a liquid material, the first elastic member 4 is preferably a member including closed cells so that entry of the liquid material into the first elastic member 4 can be avoided.

The inventor observes a state of reverberation in a case in which the Asker hardness, which is a hardness of sponge, is 10, and in a case in which the Asker hardness is 30. That is, the inventor drives the piezoelectric element 1 and vibrates the vibration body 2 only for a fixed time, and observes the vibration remaining when the piezoelectric element 1 is stopped thereafter, that is, the reverberation. As a result, the inventor confirms that the reverberation is suppressed small in the case in which the Asker hardness is 10, compared to the case in which the Asker hardness is 30.

In addition, the inventor performs an experiment to measure a reverberation time at a low temperature related to the respective first elastic members 4 having a hardness of 10, 15, and 20. It is discovered that although the elastic member is hardened at a low temperature, the state of a reaction force being small can be maintained, and the function of hindering vibration transfer is excellent.

The inventor performs an experiment by changing the thickness of the first elastic member 4 to several different thicknesses. Assuming that there is a gap of 0.85 mm, the inventor disposes the first elastic member 4 in the gap in a compressed state and measures various characteristics of a sensor, but little influence is shown in the characteristics by the difference in thickness. Therefore, a rough design can be made, that is, design tolerance can be eased. Since the first elastic member 4 including closed cells is lightweight compared to rubber or the like, the degree of influence on a frequency is very small.

Note that as illustrated in the present embodiment, the vibration body 2 preferably includes the flange portion 2c, and the first elastic member 4 is preferably in contact with the flange portion 2c. Through adopting of this configuration, the first elastic member 4 can stably support the vibration body 2. The degree of transfer of unnecessary vibration to other members from the vibration body 2 can be reduced by the first elastic member 4.

As illustrated in the present embodiment, the first elastic member 4 is preferably a member having an annular shape with a fixed thickness. Through adopting of this configuration, the vibration body 2 can be easily uniformly supported. The first elastic member 4 may be formed, for example, through punching of a plate material with a fixed thickness.

The first elastic member 4 is preferably made of at least one material selected from the group consisting of silicone, modified silicone, and urethane. Through adopting of this configuration, unnecessary vibration transfer can be effectively suppressed. The first elastic member 4 is formed through performing of a foam treatment in which a closed-cell structure can be formed in a material that satisfies the above-described conditions.

Note that among the above-described embodiments, a plurality of embodiments may be employed in an appropriate combination. Note that the above-described embodiments disclosed herein are illustrative and non-restrictive in every aspect. The scope of the present invention is defined by the terms of the claims, and intended to include any modifications within the meaning and scope equivalent to the terms of the claims.

### Reference Signs List

1 piezoelectric element
2 vibration body
2a bottom portion
2b cylindrical portion
3 adhesive sheet
4 first elastic member
5 second elastic member
6 rear cover
7 wiring board assembly
8 first filling member
9 second filling member
10 wiring
51 first housing member
52 second housing member
71, 72, 73, 74, 75 line
91, 92, 93, 94 arrow
101 ultrasonic sensor

## Claims

1. An ultrasonic sensor comprising:
a vibration body including a cylindrical portion and a bottom portion that closes one end of the cylindrical portion;
a piezoelectric element fixed to an inner surface of the bottom portion of the vibration body;
a first housing member that constitutes at least a part of a housing storing the vibration body; and
a first elastic member that is disposed while being interposed between the vibration body and the first housing member, wherein
the first elastic member has a front and rear symmetrical shape and includes a closed-cell structure.

2. The ultrasonic sensor according to claim 1, wherein
the vibration body includes a flange portion, and
the first elastic member is in contact with the flange portion.

3. The ultrasonic sensor according to claim 1 or 2,
wherein
the first elastic member is a member having an annular shape with a fixed thickness.

4. The ultrasonic sensor according to any one of claims 1 to 3, wherein
the first elastic member is made of at least one material selected from a group consisting of silicone, modified silicone, and urethane.
